# EUROPEAN PATENT APPLICATION

(11) **EP 3 540 790 A1**
(43) Date of publication of application: **18.09.2019**
(21) Application number: 18186253.3
(22) Date of filing: 30.07.2018
(51) Int. Cl.: H01L 31/18, H01L 21/683

(54) **TURNOVER MECHANISM AND COATING PRODUCTION LINE**

(30) Priority: 14.03.2018 CN 201820347129 U
(71) Applicant: Beijing Juntai Innovation Technology Co., Ltd, 100176 Beijing (CN)
(72) Inventor: Yang, Bin, Beijing, Beijing 100176 (CN)
(74) Representative: Cohausz & Florack

(57) **Abstract**

A turnover mechanism and a coating production line are disclosed, the turnover mechanism includes a jacking device (200) configured to rise or lower a carrier (100); and a turnover device (400) including a first driving member (430) and a clamping member (405), wherein the turnover device (400) and the carrier (100) are disposed above the jacking device (200), the carrier (100) is configured to carry a workpiece, the clamping member (405) is configured to clamp the carrier (100), and the first driveing member (430) is connected to the clamping member (405) and configured to drive the clamping member (405) to telescope and rotate.

## Description

### CROSS-REFERENCE TO RELATED APPLICATION

This application claims the priority of Chinese Application No. 201820347129.3 filed on March 14, 2018, which is incorporated herein in its entirety by reference.

### TECHNICAL FIELD

The present disclosure relates to the field of photovoltaic module manufacturing technology, and in particular to a turnover mechanism and a coating production line.

### BACKGROUND

Workpieces such as cells and silicon wafers need to be coated separately on both sides thereof during the coating process. The existing plate type coating equipment can only carry out the coating process unidirectionally, that is, after one surface of the workpiece is coated, the workpiece needs to be turned over for coating of the other surface. As far as a workpiece such as a cell or a silicon wafer is concerned, after an upper surface of the workpiece is coated, the workpiece needs to be output from the coating equipment onto a turnover station under the atmospheric condition for manual turnover, then the turned-over workpiece enters again the coating equipment for coating of a lower surface of the workpiece. However, after the coating of the upper surface of the workpiece is completed, the workpiece needs to be cooled to a certain temperature before being output from the coating equipment. If the workpiece enters the turnover station directly without cooling, the workpiece would crack and a carrier such as a support plate would deform due to the relatively cold atmospheric temperature. At the same time, the workpiece is susceptible to contamination in the atmosphere. In addition, the cooling process and manual turnover would also affect the proceeding of the coating process and cause labor waste.

### SUMMARY

The present disclosure has been accomplished to at least partially solve the technical problem in the prior art. The present disclosure provides a turnover mechanism and a coating production line that can achive automatic turnover of a carrier (workpiece), reduce influence of the external environment on the coating process, optimize the processing effect and improve the coating efficiency of the equipment.

According to an aspect of the present disclosure, a turnover mechanism is provided, including:
a jacking device configured to rise or lower the carrier; and
a turnover device including a first driving member and a clamping member,
wherein the turnover device and the carrier are disposed above the jacking device, the carrier is configured to carry the workpiece, the clamping member is configured to clamp the carrier, and the first driving member is connected to the clamping member and configured to drive the clamping member to telescope and rotate.

In an exemplary embodiment, the clamping member may be provided with a slot that receives the carrier.

In an exemplary embodiment, the clamping member may further be provided with a fixing member, which is detachably disposed on a bottom surface of the slot, and an axial direction of the fixing member is parallel with a direction in which the carrier is received in the slot.

In an exemplary embodiment, the fixing member may be a pin, and the carrier may be a support plate.

In an exemplary embodiment, the jacking device may include a supporting member and a cylinder, one end of the supporting member being connected to a cylinder rod of the cylinder, and the other end of the supporting member being provided with an engaging portion that supports the carrier.

In an exemplary embodiment, the supporting member may include a first pair of support portions and a second pair of support portions, the first pair of support portions and the second pair of support portions may be symmetrically disposed on opposite sides of the carrier, respectively, and the engaging portion is disposed on a side of each of the first pair of support portions and the second pair facing the carrier.

In an exemplary embodiment, a latching slope may be provided on the engaging portion on each of opposite sides of each of the first pair of support portions and the second pair of support portions, the two ends of the carrier may be each engaged with the latching slope of the engaging portion, respectively.

In an exemplary embodiment, the turnover mechanism may further include a transport device configured to transport the carrier, the transport device being disposed below the turnover device.

In an exemplary embodiment, the transport device may include a transport roller and a second driving member connected to the transport roller and configured to drive the transport roller to telescope and rotate.

In an exemplary embodiment, the transport roller may include a large diameter section and a small diameter section, the large diameter section being connected to the second driving member, an upper end surface of the small diameter section being in contact with the carrier.

In an exemplary embodiment, the clamping member may include a clamping body, an upper clamping portion and a lower clamping portion, one end of the clamping body being connected to the first driving member, the other end of the clamping body being connected to the upper clamping portion and the lower clamping portion, respectively, and the slot is formed between the upper clamping portion and the lower clamping portion.

In an exemplary embodiment, the ends on opposite sides of the upper clamping portion and the lower clamping portion may each be provided with a chamfer.

In an exemplary embodiment, the fixing member may have a taper shape, and a large diameter end of the fixing member may be detachably connected to a bottom surface of the slot.

In an exemplary embodiment, the turnover mechanism may be disposed in a coating vacuum chamber of a coating production line, and the workpiece may be a cell or a silicon wafer.

According to another aspect of the present disclosure, a coating production line is provided, comprising: a coating vacuum chamber, wherein a workpiece front coating station is disposed at an infeed side of the coating vacuum chamber, a workpiece back coating station is disposed at an outfeed side of the coating vacuum chamber, a workpiece turnover station is disposed between the workpiece front coating station and the workpiece back coating station, and the workpiece turnover station is provided with the turnover mechanism according to the first aspect of the present disclosure.

The turnover mechanism and the coating production line according to the present disclosure realize automatic turnover of the carrier (workpiece), and also realize cell turnover operation in the vacuum chamber, thereby avoiding influence of the external environment on the coating process, optimizing the processing effect and improving the coating efficiency.

### BRIEF DESCRIPTION OF THE DRAWINGS

The embodiments of the present disclosure will now be further described in detail with reference to the accompanying drawings.
FIG. 1 is a front view showing a turnover mechanism of an embodiment of the present disclosure;
FIG. 2 is a plan view showing a turnover mechanism of an embodiment of the present disclosure;
FIG. 3 is a front view showing a turnover device of an embodiment of the present disclosure;
FIG. 4 is a side view showing a turnover device of an embodiment of the present disclosure;
FIG. 5 is a plan view showing a turnover device of an embodiment of the present disclosure;
FIG. 6 is a state diagram showing a jacking device supporting a carrier of an embodiment of the present disclosure; and
FIG. 7 is a schematic view showing a coating production line of an embodiment of the present disclosure.

### DETAILED DESCRIPTION

The embodiments of the present disclosure will be described in detail below with reference to the accompanying drawings. In the drawings, the same or similar reference numerals indicate the same or similar elements or elements having the same or similar functions. The embodiments described hereinbelow with reference to the drawings are illustrative and are used to explain the present disclosure only, which may not be interpreted as limitations to the present disclosure.

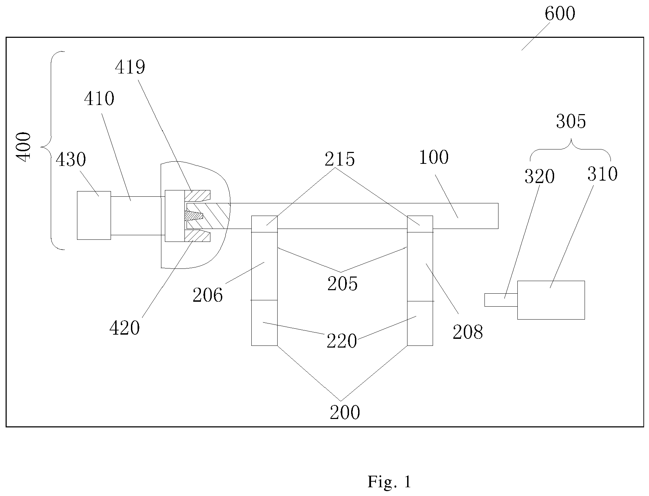

As shown in FIG. 1 to FIG. 5, a turnover mechanism according to the embodiment of the present disclosure includes a jacking device 200 configured to rise or lower a carrier 100 that carrys a workpiece such as a cell or a silicon wafer (not shown in the drawings) to be coated and a turnover device 400 configured to turn over the carrier 100, and the turnover device 400 and the carrier 100 are disposed above the jacking device 200. The turnover device 400 includes a clamping member 405 configured to clamp the carrier 100, and a first driving member 430, which is connected to the clamping member 405 and configured to drive the clamping member 405 to telescope and rotate. In an exemplary embodiment, the clamping member 405 is provided with a slot 425 that receives the carrier 100. In an exemplary embodiment, the clamping member 405 is further provided with a fixing member 500, which is located on a bottom surface of the slot 425, and an axial direction of the fixing member 500 is parallel with a direction in which the carrier 100 is received in the slot 425. In an exemplary embodiment, the fixing member 500 may be, for example, in the form of a pin, and the carrier 100 may be, for example, a support plate. In an exemplary embodiment, a fixing hole (not shown) mating with the fixing member 500 may be provided on a side surface of the carrier 100.

In an exemplary embodiment, as shown in Figs. 1 and. 6, the jacking device 200 may include a supporting member 205 and a cylinder 220, one end of the supporting member 205 is connected to a cylinder rod of the cylinder 220, and the other end of the supporting member 205 is provided with an engaging portion 215 for supporting the carrier 100. For ease of processing, the engaging portion 215 may be integrally formed with the supporting member 205. In an exemplary embodiment, for example, the supporting member 205 may be in the form of a bracket. The supporting member 205 may include a first pair of support portions 206, 206, which are symmetrically disposed on opposite sides of the carrier 100, and the engaging portion 215 is disposed on a side of each of the first pair of support portions 206, 206 facing the carrier 100.

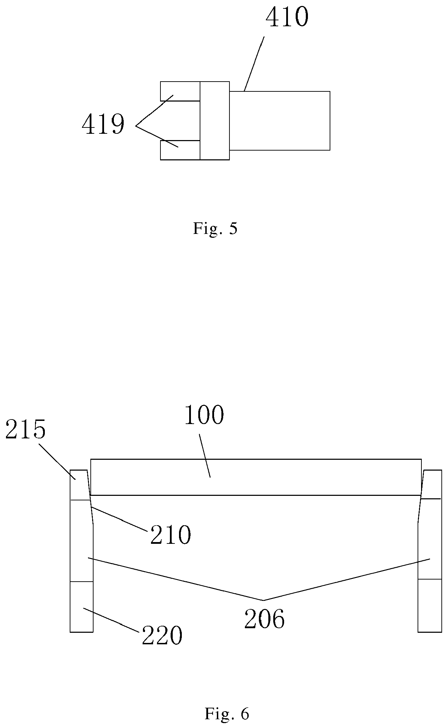

In an exemplary embodiment, in order to ensure the stability in turning over the carrier 100, as shown in Figs. 1 and 6, the supporting member 205 may further include a second pair of support portions 208, 208, which are symmetrically disposed on opposite sides of the carrier 100, and the engaging portion 215 is disposed on a side of each of the second pair of support portions 208, 208 facing the carrier 100. A latching slope 210 is provided on the engaging portion 215 on each of opposite sides of each pair of support portions, and the two ends of the carrier 100 may be respectively engaged with the latching slopes 210 of two engaging portions 215.

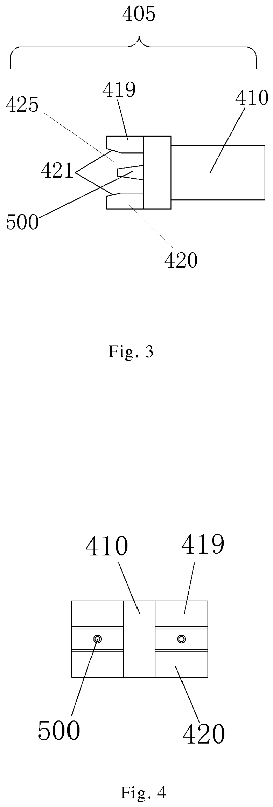

In an exemplary embodiment, as shown in FIGs. 3 to 5, the clamping member 405 may include a clamping body 410, an upper clamping portion 419 and a lower clamping portion 420. One end of the clamping body 410 is connected to the first driving member 430, the other end of the clamping body 410 is fixedly connected to the upper clamping portion 419 and the lower clamping portion 420, respectively, and the slot 425 is formed between the upper clamping portion 419 and the lower clamping portion 420. During the carrier 100 is received in the slot 425, the upper clamping portion 419 is pressed against the upper surface of the carrier 100, and the lower clamping portion 420 is pressed against the lower surface of the carrier 100 so that an edge of the carrier 100 is received in the slot 425, thereby being clamped and fixed in place.

In an exemplary embodiment, the ends of the upper clamping portion 419 and the lower clamping portion 420 on sides opposite to each other may each be provided with a chamfer 421 to facilitate reception of the carrier 100 into the slot 425.

In an exemplary embodiment, for example, the fixing member 500 may have a taper shape (the large diameter end of the fixing member 500 is detachably connected to the bottom surface of the slot 425) to facilitate insertion of the fixing member 500 into the fixing hole (not shown) on the carrier 100.

The working principle and process of the turnover mechanism of the embodiment of the present disclosure are as follows:
In step S100, the carrier 100 carrying the workpiece such as a cell or a silicon wafer is transported to a workpiece turnover station.

In step S200, the jacking device 200 is driven to rise to jack up the carrier 100 to a preset height; wherein the preset height is preferably a height at which the position of the jacked up carrier 100 is flush with the position of the clamping member 405.

In step S300, the clamping member 405 is driven to protrude by the first driving member 430, so that one end (edge) of the carrier 100 is received in the slot 425 of the clamping member 405, thereby being clamped and fixed in place. In an exemplary embodiment, the fixing of the carrier 100 may further be enhanced by mating the fixing member 500 provided in the slot 425 with a fixing hole (not shown) of the carrier 100, so as to prevent the carrier 100 from slipping off from the slot 425 during the turning-over process.

In step S400, in order to ensure sufficient turnover space under the carrier 100, the jacking device 200 is driven to lower after the carrier 100 is clamped and fixed by the turnover device 400.

In step S500, the clamping member 405 clamping the carrier 100 is driven by the first driving member 430 to turn over by 180°, so that the carrier 100 (workpiece) is turned-over.

In step S600, the jacking device 200 is driven to rise, so as to support the turned-over carrier 100.

In step S700, the clamping and fixing of the carrier 100 by the clamping member 405 are released and the clamping member 405 is driven by the first driving member 430 to retract, such that the clamping member 405 is separated from the turned-over carrier 100.

In step S800, the jacking device 200 is driven to lower the turned-over carrier 100 to go through the next process.

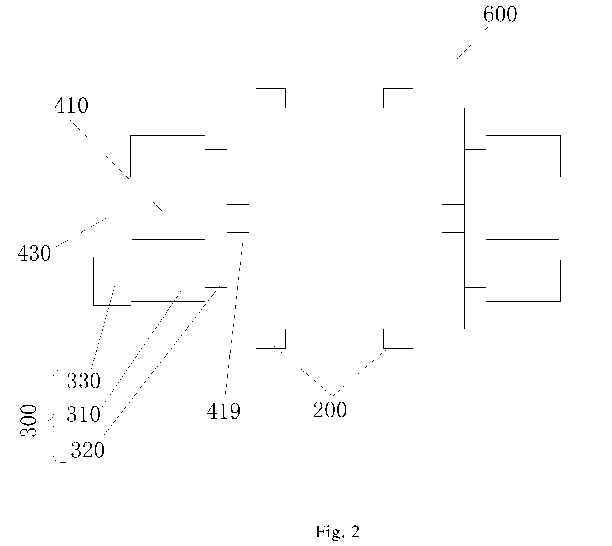

In an exemplary embodiment, as shown in Figs. 1 and 2, the turnover mechanism may further include a transport device 300 for transporting the carrier 100, the transport device 300 being disposed below the turnover device 400. Specifically, the transport device 300 may include a transport roller 305, and a second driving member 330 that is connected to the transport roller 305 and configured to drive the transport roller 305 to telescope and rotate. The carrier 100 may be placed on the transport roller 305, and be transported by means of the rotation of the transport roller 305 and a frictional force thereof against the carrier 100. In the mean time, by means of telescoping of the transport roller 305, the carrier 100 may obtain sufficient turnover space, so that interference of the carrier 100 with the transport roller 305 in the turning-over process is prevented.

In addition, as shown in Figs. 1 and 2, the transport roller 305 includes a large diameter section 310 and a small diameter section 320. The large diameter section 310 is connected to the second driving member 330, the small diameter section 320 is connected to the large diameter section 310, and the upper end surface of the small diameter section 320 is in contact with the carrier 100. In an exemplary embodiment, the large diameter section 310 and the small diameter section 320 may be integrally formed, and a stepped surface may be formed between the large diameter section 310 and the small diameter section 320 and configured to limit the position of the carrier 100 during the transportaion process of the carrier 100.

In an exemplary embodiment, both the first driving member 430 and the second driving member 330 may be, but not limited to, a retractable magnetic fluid. In an exemplary embodiment, both the first driving member 430 and the second driving member 330 may include members such as a rotary cylinder and a lifting cylinder, or may include members such as an electric motor, a gear shaft, a gear, a ball screw, and the like.

In addition, as shown in Figs. 1 to 6, the working principle and process of the turnover mechanism of another embodiment of the present disclosure are as follows:
In step S10, after the carrier 100 carrying the workpiece is transported to the workpiece turnover station by the transport roller 305, the transport device 300 stops operating.

In step S20, the jacking device 200 is driven to rise to jack up the carrier 100 to a preset height, such that the carrier 100 is released from the transport roller 305; wherein the position of the jacked up carrier 100 is flush with the position of the clamping member 405.

In step S30, the clamping member 405 is driven to protrude by the first driving member 430, so that the edge (end) of the carrier 100 is received into the slot 425 of the clamping member 405, thereby being clamped and fixed in place. In an exemplary embodiment, the fixing of the carrier 100 may further be enhanced by mating the fixing member 500 provided in the slot 425 with a fixing hole (not shown) provided on a side surface of the carrier 100 to prevent the carrier 100 from slipping off from the slot 425 during the turning-over process.

In step S40, the jacking device 200 is driven to lower while the transport roller 305 is driven by the second driving member 330 to retract so that there is sufficient turnover space under the carrier 100, thus interference of the carrier 100 with the transport roller 305 in the turning-over process is prevented.

In step S50, the clamping member 405 clamping the carrier 100 is driven by the first driving member 430 to turn over by 180°, so that the carrier 100 (workpiece) is turned-over.

In step S60, the jacking device 200 is driven to rise to support the turned-over carrier 100.

In step S70, the clamping and fixing of the carrier 100 by the clamping member 405 are released and the clamping member 405 is driven by the first driving member 430 to retract, such that the clamping member 405 is separated from the turned-over carrier 100.

In step S80, the transport roller 305 is driven to protrude.

In step S90, the jacking device 200 is driven to lower the turned-over carrier 100 such that the carrier 100 contacts the protruding transport roller 305, which transports the turned-over carrier 100 to the next working station.

The turnover mechanism of the present disclosure is applicable to a cell coating process, a silicon wafer coating process, or any other coating process that requires turning over a workpiece.

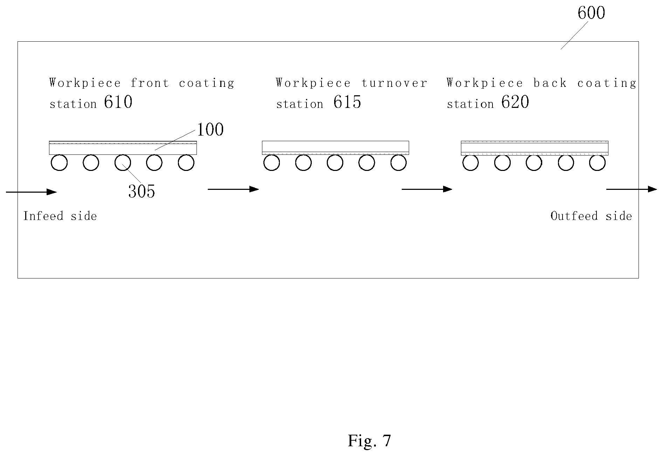

In addition, as shown in FIG. 7, the embodiment of the present disclosure further provides a coating production line (a coating process production line), which includes a coating vacuum chamber 600, a workpiece (for example, a cell or a silicon wafer) front coating station 610 is disposed at an infeed side of the coating vacuum chamber 600, a workpiece back coating station 620 is disposed at an outfeed side of the workpiece coating vacuum chamber 600, a workpiece turnover station 615 is disposed between the workpiece front coating station 610 and the workpiece back coating station 620, and the workpiece turnover station 615 is provided with the turnover mechanism according to any embodiment of the present disclosure. By means of the coating production line according to the embodiment of the present disclosure, the turnover of the workpiece can be performed in a vacuum chamber, thereby avoiding the influence of the external environment on the coating process, optimizing the process effect, and improving the coating efficiency.

The turnover mechanism and the coating production line according to the embodiments of the present disclosure realize automatic turnover of the carrier (workpiece), and also realize turnover operation of the workpiece in a vacuum chamber, thereby avoiding the influence of the external environment on the coating process, and optimizing the process effect, and improving the coating efficiency.

The configurations, features, and effects of the present disclosure have been described in detail above with reference to the accompanying drawings, which are merely exemplary embodiments of the present disclosure, but the scope of the present disclosure is not limited thereto. Any changes or substitutions that can be easily conceived of by those skilled in the art within the scope of the present disclosure are intended to be included within the scope of the present disclosure.

### LIST OF REFERENCE SIGNS

100 carrier
200 jacking device
210 latching slope
205 supporting member
206 first pair of support portions
208 second pair of support portions
215 engaging portion
220 cylinder
300 transport device
305 transport roller
310 large diameter section
320 small diameter section
330 second driving member
400 turnover device
405 clamping member
410 clamping body
419 upper clamping portion
420 lower clamping portion
421 chamfer
425 slot
430 first driving member
500 fixing member
600 coating vacuum chamber
610 workpiece front coating station
615 workpiece turnover station
620 workpiece back coating station

## Claims

1. A turnover mechanism, comprising:
a jacking device (200) configured to rise or lower a carrier (100); and
a turnover device (400) including a first driving member (430) and a clamping member (405),
wherein the turnover device (400) and the carrier (100) are disposed above the jacking device (200), the carrier (100) is configured to carry a workpiece, the clamping member (405) is configured to clamp the carrier (100), and the first driving member (430) is connected to the clamping member (405) and configured to drive the clamping member (405) to telescope and rotate.

2. The turnover mechanism according to claim 1, wherein
the clamping member (405) is provided with a slot (425) that receives the carrier (100).

3. The turnover mechanism according to claim 2, wherein
the clamping member (405) is further provided with a fixing member (500), which is detachably disposed on a bottom surface of the slot (425), an axial direction of the fixing member (500) being parallel with a direction in which the carrier is received in the slot (425).

4. The turnover mechanism according to claim 3, wherein
the fixing member (500) is a pin, and the carrier (100) is a support plate.

5. The turnover mechanism according to claim 1, wherein the jacking device (200) comprises a supporting member (205) and a cylinder (220), one end of the supporting member (200) being connected to a cylinder rod of the cylinder (220), and the other end of the supporting member (205) is provided with an engaging portion (215) that supports the carrier (100).

6. The turnover mechanism according to claim 5, wherein
the supporting member (205) comprises a first pair of support portions (206) and a second pair of support portions (208), the first pair of support portions (206) and the second pair of support portions (208) being symmetrically disposed on opposite sides of the carrier (100), respectively, and the engaging portion (215) is disposed on a side of each of the first pair of support portions (206) and the second pair of support portions (208) facing the carrier (100).

7. The turnover mechanism according to claim 6, wherein a latching slope (210) is provided on the engaging portion (215) on each of opposite sides of each of the first pair of support portions (206) and the second pair of support portions (208), and two ends of the carrier (100) are each engaged with the latching slope (210) of the engaging portion (215), respectively.

8. The turnover mechanism according to claim 1, further comprising a transport device (300) configured to transport the carrier (100), the transport device (300) being disposed below the turnover device (400).

9. The turnover mechanism according to claim 8, wherein the transport device (300) comprises a transport roller (305) and a second driving member (330) connected to the transport roller (305) and configured to drive the transport roller (305) to telescope and rotate.

10. The turnover mechanism according to claim 9, wherein the transport roller (305) includes a large diameter section (310) and a small diameter section (320), the large diameter section (310) being connected to the second driving member (330), an upper end surface of the small diameter section (320) being in contact with the carrier (100).

11. The turnover mechanism according to claim 2, wherein the clamping member (405) comprises a clamping body (410), an upper clamping portion (419) and a lower clamping portion (420), one end of the clamping body (410) being connected to the first driving member (430), the other end of the clamping body (410) being fixedly connected to the upper clamping portion (419) and the lower clamping portion (420), respectively, and the slot (425) being formed between the upper clamping portion (419) and the lower clamping portion (420).

12. The turnover mechanism according to claim 11, wherein ends on opposite sides of the upper clamping portion (419) and the lower clamping portion (420) are each provided with a chamfer (421).

13. The turnover mechanism according to claim 2, wherein the fixing member (500) has a taper shape, a large diameter end of the fixing member (500) being detachably connected to a bottom surface of the slot (425).

14. The turnover mechanism according to any one of claims 1 to 13, wherein the turnover mechanism is disposed in a coating vacuum chamber (600) of a coating production line, and the workpiece is a cell or a silicon wafer.

15. A coating production line comprising a coating vacuum chamber (600), wherein a workpiece front coating station (610) is provided at an infeed side of the coating vacuum chamber (600) and a workpiece back coating station (620) is provided at an outfeed side of the coating vacuum chamber (600), a workpiece turnover station (615) is provided between the workpiece front coating station (610) and the workpiece back coating station (620), and the workpiece turnover station (615) is provided with the turnover mechanism according to any one of claims 1 to 14.
